Europäisches Patentamt

European Patent Office

Office européen des brevets

(11) Numéro de publication: **0 334 747**
**A1**

(12) # DEMANDE DE BREVET EUROPEEN

(21) Numéro de dépôt: **89400787.1**

(22) Date de dépôt: **21.03.89**

(51) Int. Cl.⁴: **H 01 L 23/56**
**H 01 L 23/50**

(30) Priorité: **25.03.88 FR 8803950**

(43) Date de publication de la demande:
**27.09.89 Bulletin 89/39**

(84) Etats contractants désignés: **DE GB IT NL SE**

(71) Demandeur: **THOMSON HYBRIDES ET MICROONDES**
**173, bld Haussmann**
**F-75008 Paris (FR)**

(72) Inventeur: **Malbe, Serge**
**THOMSON-CSF SCPI - 51, Esplanade du Gén. de Gaulle**
**CEDEX 67 F-92045 Paris la Défense (FR)**

**Fouche, Alain**
**THOMSON-CSF SCPI - 51, Esplanade du Gén. de Gaulle**
**CEDEX 67 F-92045 Paris la Défense (FR)**

**Da Silva, Evelyne**
**THOMSON-CSF SCPI - 51, Esplanade du Gén.de Gaulle**
**CEDEX 67 F-92045 Paris la Défense (FR)**

(74) Mandataire: **Taboureau, James et al**
**THOMSON-CSF SCPI 51, Esplanade du Général de**
**Gaulle**
**F-92045 Paris La Défense - Cédex 67 (FR)**

(54) Dispositif d'interconnexion et de protection d'une pastille nue de composant hyperfréquence.

(57) L'invention se rapporte à l'interconnexion d'une pastille de circuit intégré hyperfréquence (MMIC).

Pour interconnecter une pastille nue, non protégée, de MMIC, un substrat céramique (1) porte un circuit double face. Sur la première face est disposé un réseau de lignes microbandes (2) qui rayonnent du centre vers la périphérie. Sur la deuxième face, métallisée en plan de masse (8), est fixée la pastille nue de MMIC (18) et son environnement hyperfréquence (19,20). Le circuit hyperfréquence (18,19,20) est interconnecté avec le réseau de microbandes (2) au moyen de trous (5) métallisés bouchés. Une semelle (12), comportant un logement (13) pour le MMIC (18) est fixée sur le plan de masse (8). La première face peut comporter des composants autoprotégés (21,22,23)

Application aux circuits hyperfréquences, cascadables, jusque 60 GHz.

FIG 7

Description

## DISPOSITIF D'INTERCONNEXION ET DE PROTECTION D'UNE PASTILLE NUR DE COMPOSANT HYPERFREQUENCE.

La présente invention concerne un dispositif d'interconnexion et de protection d'une puce de circuit intégré hyperfréquence réalisé en matériaux III-V, tel que GaAs. Un circuit intégré hyperfréquence monté dans ce dispositif ne voit pas ses performances diminuées par le dispositif, dans une gamme de fréquences allant du continu jusqu'au moins 40 GHz, et 60 GHz si le substrat est adapté.

Il est connu que les circuits intégrés hyperfréquences, souvent appelés MMIC, pour Microwave Monolithic Integrated Circuits, sont d'un emploi délicat.

En premier lieu, ces circuits intégrés sont très généralement en GaAs, ou matériaux comparables tels que AlGaAs, InP..., dont la protection de surface $Si_3 N_4$ n'est pas optimale, comme pour un circuit en silicium. Il faut dont les protéger des contraintes climato-mécaniques par un boitier d'encapsulation.

Mais par ailleurs, il est également connu qu'un MMIC qui fonctionne bien à l'état de puce nue voit ses caractéristiques fortement dégradées lorsqu'on l'encapsule dans un boitier. De nombreux paramètres interviennent, parmi lesquels le volume de la cavité du boitier et le passage des connexions d'accès à travers les parois du boitier. Ce sont soit des connexions coaxiales, en perle de verre, ce qui est illogique puisque le circuit associé à un MMIC est très généralement en microbandes, soit des connexions plates qui passent à travers le boitier, dans le plan de collage du couvercle sur l'embase, dans l'épaisseur d'une couche de verre, mais qui présente des fuites en hyperfréquences.

Des résultats néanmoins acceptables sont obtenus avec des boitiers complexes, volumineux et côuteux, mais :
- ils ne sont pas compatibles avec un environnement de circuit en microrubans,
- ils ne sont pas cascadables, type de montage fréquemment utilisé en hyperfréquences,
- leur perte d'insertion est relativement élevée, en raison de leur système de connexions d'accès.

Le dispositif selon l'invention apporte une solution à ces problèmes d'environnement d'une puce de MMIC. en prenant comme élément de départ un substrat mince en céramique qui constitue à lui seul une partie d'un circuit en microrubans. C'est à dire que ce substrat céramique supporte la puce du MMIC et les lignes microrubans qui permettent d'interconnecter cet élément avec d'autres éléments comparables - montage en cascade - ou avec un circuit extérieur en microrubans.

Mais comme la puce du MMIC ne peut pas être protégée par une couche de verre ou une goutte de polymère, elle est disposée, non plus comme dans l'art connu sur la face du substrat qui porte l'interconnexion en microbandes, et qui constitue normalement la face supérieure d'un circuit hyperfréquence, mais au contraire sous ce substrat, et elle est protégée par la semelle de fixation du dispositif, qui sert également de radiateur, dans laquelle un amincissement local offre une alvéole pour loger la puce de MMIC et d'autres composants éventuellement, tels que des capacités.

La puce de MMIC, et les autres éventuels composants, sont réunis au réseau de microbandes de la face supérieure au moyen de trous métallisés, qui sont hermétiquement bouchés.

Ainsi, le dispositif selon l'invention est essentiellement constitué par un substrat gravé en double face, qui porte sur sa face inférieure au moins un composant hyperfréquence en puce nue, protégée par la semelle de fixation dans laquelle est pratiquée une alvéole, et sur sa face supérieure au moins un réseau de microbandes et éventuellement des composants tels que capacités, selfs et puces en silicium glassivé, les deux faces étant interconnectées au moyen de trous métallisés bouchés par de la brasure. Bien entendu, la semelle est hermétiquement brasée sur le substrat double face.

L'invention qui a été mise au point plus spécialement pour les circuits intégrés, s'applique également aux transistors hyperfréquences.

De façon plus précise, l'invention concerne un dispositif d'interconnexion et de protection d'une pastille nue de composant semiconducteur hyperfréquence, réalisé en matériaux du groupe III-V, caractérisé en ce qu'il comporte :
- un substrat mince en matériau diélectrique, dont une première face supporte un réseau de lignes microbandes et dont une deuxième face supporte une métallisation de plan de masse pour les lignes microbandes de la première face,
- au moins une pastille de composant semiconducteur hyperfréquence, fixée sur la métallisation de plan de masse de la deuxième face du substrat, connectée électriquement aux lignes microbandes de la première face du substrat au moyen de trous métallisés bouchés,
- une semelle métallique, dans laquelle une alvéole dégage un logement pour le composant semiconducteur fixé sur la deuxième face du substrat, dont la métallisation de plan de masse est brasée sur la semelle au moyen d'une préforme de brasure.

L'invention sera mieux comprise, et ses avantages ressortiront mieux de la description détaillée qui suit d'un exemple de réalisation, appuyée sur les figures jointes en annexes, qui représentent :
- fig. 1 : vue en plan de la face supérieure du substrat d'un dispositif selon l'invention.
- fig. 2 : vue en plan de la face inférieure du substrat d'un dispositif selon l'invention,
- fig. 3 : vue en plan de la semelle métallique et de la préforme de brasure sur le substrat,
- fig. 4 : vue en plan du montage d'une puce de MMIC sur la face inférieure du substrat,
- fig. 5 et 6 : vues en coupe d'un dispositif selon l'invention, dans deux modèles de réalisation,
- fig. 7 : vue éclatée dans l'espace d'un dispositif selon l'invention.

- fig. 8 et 9 : montage en cascade, vu en plan et en coupe, de plusieurs dispositifs selon l'invention.

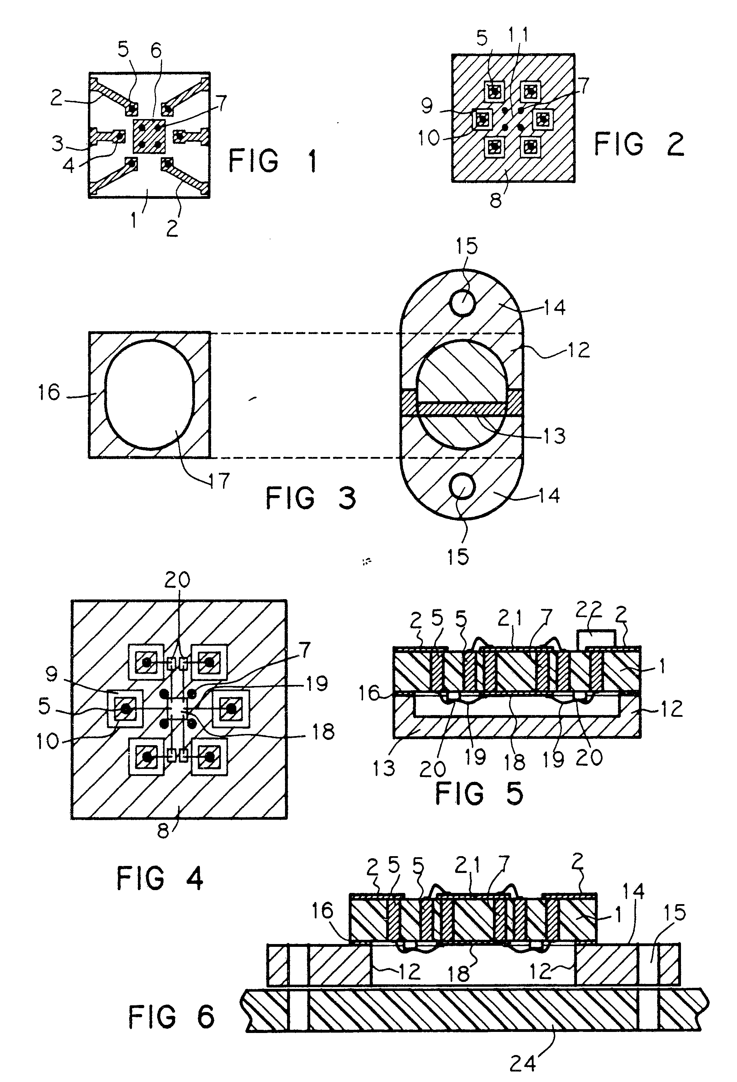

Les figures 1 et 2 représentent le substrat du dispositif de l'invention. C'est une plaquette de céramique, carrée ou rectangulaire, d'environ 5 mm de côté sur 0,25 à 0,75 mm d'épaisseur. Elle est préférablement en alumine à 99,6 % de pureté.

Sur une première face, en figure 1, que l'on peut considérer comme la face supérieure du dispositif dans des conditions normales d'emploi, le substrat 1 supporte un réseau de lignes microbandes 2, qui se dirigent depuis une plage centrale vers la périphérie du substrat.

Le nombre de microbandes 2 représentées sur les figures ne limite en rien la portée de l'invention : il y en a autant que nécessitées par la puce du MMIC ou transistor associé à ce substrat. Ces microbandes sont réalisées préférablement par pulvérisation cathodique ou évaporation de métal sous vide, ou par sérigraphie. De même, elles peuvent aboutir sur les quatre côtés du substrat 1, comme on le verra ultérieurement, mais les montages habituels en hyperfréquences exigent qu'elles aboutissent sur au moins deux côtés.

Ces microbandes ont deux particularités :
- elles comportent toutes deux plages de métallisations 3 et 4 à leurs deux extrêmités,
- leur extrémité "centrale" par rapport au substrat 1 entoure un trou 5 qui traverse la plaquette céramique.

La plage métallisée 3, à l'extrêmité en périphérie du substrat 1, permet de cabler par les techniques usuelles un fil ou ruban métallique de liaison avec le circuit extérieur, en environnement microrubans. La plage métallisée 4, à l'extrêmité "centrale" par rapport au substrat 1, est percée par un trou 5 et assure le contact électrique avec ce trou métallisé sur lequel on reviendra plus loin.

Cette face microruban comporte également une plage centrale de métallisation 6, reliée par au moins un trou métallisé 7 à l'autre face du substrat 1.

La seconde face du substrat 1 ou face inférieure, en figure 2, est de type coplanaire : elle comporte simplement une métallisation 8 qui constitue le plan de masse pour les lignes microbandes 2 de la première face. Une gravure dans la métallisation 8 crée des réserves 9 qui isolent de petites plages de métallisation 10 autour des trous 5. Les trous 7 sont en contact électrique avec la métallisation 8.

La plage centrale 11, sur le plan de masse 8, comprise entre les réserves 9, est de dimensions suffisantes pour pouvoir y fixer, par brasure ou colle conductrice, une puce de MMIC, dont le substrat est donc à la masse du plan de masse 8.

La totalité des trous 5 et 7 qui traversent le substrat céramique 1 sont métallisés au cours de l'opération de métallsation des deux faces, avant gravure, puis sont bouchés avec une pâte à braser or-étain ou or-germanium; une refusion à température adéquate selon la pâte à braser forme un joint hermétique dans chaque trou.

La ou les puces de MMIC qui est fixée sur la face inférieure du substrat 1, est connectée par des fils ou rubans métalliques aux trous métallisés et bouchés 5, qui sont eux-mêmes en liaison électrique avec le réseau de microbandes 2 : dans le dispositif d'interconnexion selon l'invention, le circuit d'interconnexion est sur une première face du substrat céramique, et le circuit intégré hyperfréquence est sur une deuxième face de ce même substrat, et la liaison se fait par des trous métallisés bouchés.

En hyperfréquences, les éléments de circuits tel que celui décrit, comportant un petit substrat céramique, sont le plus souvent fixés sur une semelle métallique, qui a un double objectif : transmettre la chaleur dégagée en fonctionnement, et manipuler pour la mesure électrique et fixer cet élément de circuit hyperfréquence.

La figure 3 représente une vue en plan de la semelle du dispositif d'interconnexion selon l'invention, et, à côté, de la préforme de brasure de la semelle.

La semelle métallique du dispositif comprend au moins une partie centrale 12 dont les dimensions sont les mêmes que celles du substrat 1. Elle a une épaisseur comprise entre 0,5 et 1 mm, et, afin de pouvoir la braser sur le plan de masse 8 du substrat 1, elle comporte dans sa partie centrale un amincissement en 13, créant ainsi une alvéole d'environ 0,25 -0,30 mm de profondeur, suffisante pour loger la puce du MMIC. De façon à mieux montrer le profil de la semelle, sa coupe est superposée à son plan, sur la figure 3.

La semelle 12 peut également comporter, sur deux côtés opposés, deux embouts métalliques 14, chacun percé d'un trou 15, qui permettent de fixer le dispositif sur un support.

Une préforme de brasure 16 permet de fixer hermétiquement la semelle 12 sur le plan de masse 8 du dispositif d'interconnexion. Cette préforme 16 a elle aussi les mêmes dimensions que le substrat 1, et elle est ajourée d'un trou centrale 17 pour laisser la place à la puce de MMIC et à ses connexions et composants annexes.

Une vue en plan, agrandie par rapport à la figure 2, montre en figure 4 l'agencement du circuit sur la face inférieure du circuit d'interconnexion. Au moins une puce 18 de MMIC ou de transistor est brasée sur la plage centrale 11 du plan de masse 8. Par ses plots de connexions, elle est reliée par fils ou rubans métalliques 19 à un circuit d'environnement, qui peut comprendre des selfs - par la longueur des fils 19 - des capacités 20, ou d'autres puces de semiconducteurs - non représentées -. De façon plus générale, cette face du substrat céramique 1 comporte au moins une puce nue en matériau III-V et tout son environnement pour lequel les longueurs de liaisons sont cruciales. La sortie de ce circuit se fait par connexion sur les trous métallisés bouchés 5, qui sont en contact avec le circuit microbandes sur l'autre face du substrat.

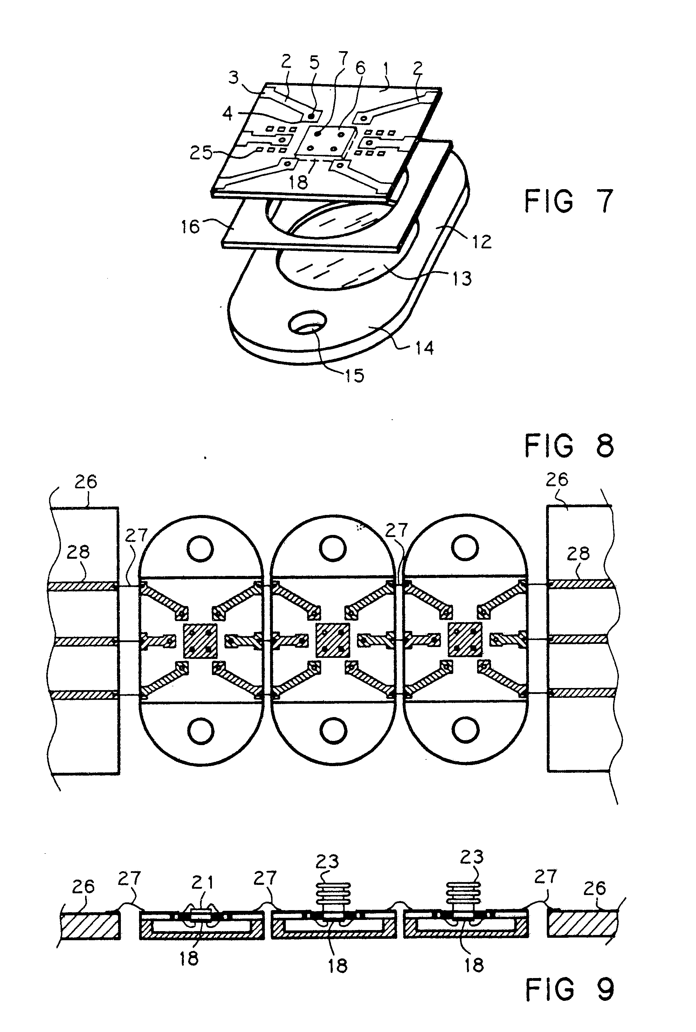

L'objet de la figure 5, qui donne une vue en coupe du dispositif selon l'invention, est de mettre en évidence l'aspect double face du circuit. Sur la face inférieure, les composants d'environnement immédiat d'au moins une puce nue 18, au GaAs par exemple. Cette puce est protégée des contraintes climato-mécaniques par l'alvéole creusée dans la semelle 12. Sur la face supérieure, il y a au moins le réseau de microbandes 2 mais il peut également y avoir un circuit électronique complémentaire, tel que par exemple une puce de régulateur de tension 21 - en silicium glassivé ou protégé par une gouttte de vernis - une ou des capacités 22 plus volumineuses, ou un radiateur thermique 23 - montré en figure 8 - La présence des trous métallisés bouchés 7 qui met la plage métallisée 6, sur la face supérieure, au potentiel du plan de masse 8, sur la face inférieure, permet de fournir une tension régulée, par exemple, à la puce de MMIC au moyen d'un trou 5.

Le dispositif selon l'invention, tel que représenté en figure 5, correspond au cas où la semelle est limitée à sa partie centrale 12, sans les embouts 14. Ce dispositif peut être collé ou brasé sur un support. Le circuit double face assure l'interconnexion du MMIC, et la semelle en assure la protection : ce n'est cependant pas un boîtier d'encapsulation.

En effet, comme le montre la figure 6, l'alvéole dans la semelle 12 peut avoir une épaisseur égale à celle de la semelle, qui est alors percée. Ce type de dispositif permet d'atteindre le circuit hyperfréquence du MMIC sur la face inférieure du substrat 1, d'y faire des mesures, et de le régler, par exemple. Dans ce cas, la semelle est préférentiellement munie d'embouts 14 : en service normal, elle sera brasée et/ou vissée sur un support 24, qui se substitue à la membrane 13 de l'alvéole pour protéger la puce du MMIC : le dispositif d'interconnexion est dans ce cas refermé sur lui même par le support 24, céramique ou métallique.

La figure 7 donne une vue éclatée dans l'espace d'un dispositif d'interconnexion selon l'invention. La face supérieure du substrat 1 y est représentée intentionnellement dépourvue de tout composant autre que les microbandes 2, avec leurs plages 3 et 4, et les trous métallisés bouchés 5 et 7 : ceci afin de ne pas introduire de confusion, puisque le circuit intégré MMIC 18 - représenté en pointillés - et son environnement immédiat sont placés sur la face inférieure du substrat 1.

La face supérieure de ce circuit d'interconnexion peut également comporter, à proximité des microbandes 2, de petits plots métallisés 25 qui servent, comme il est connu, à régler l'impédance de ligne. Celle-ci est également définie, selon des lois connues, par la largeur d'une ligne microbande 2 et par l'épaisseur et la constante diélectrique du substrat 1. Il est donc possible, en jouant sur ces trois données, d'obtenir un réseau d'interconnexion dont les impédances de lignes sont parfaitement adaptées à la fréquence.

C'est ainsi que le dispositif selon l'invention atteint les performances suivantes :
- pertes en transmission : 1 dB de 0 à 40 GHz
- pertes par réflexion : ≤ 10 dB de 0 à 40 GHz, ces deux valeurs incluant les pertes en transmission et par réflexion du montage de mesure,
- isolation entre chaque paire de microbandes : > 30 dB de 0 à 20 GHz
- herméticité : 10-7 atm./cm³/s pour l'hélium, pour un circuit dont la semelle est alvéolée.

Le coût de ce circuit d'interconnexion est faible dans la mesure où la semelle est une plaque métallique de forme simple, seulement creusée en son centre, et où le passage entre les deux faces du circuit se fait au moyen de trous bouchés par une crème à braser.

Le réseau d'interconnexion étant de type microbandes est parfaitement adapté à un environnement en microbandes, sans passer par des connecteurs coaxiaux, et il est cascadable, comme le montrent les figures 8 et 9.

Celles-ci donnent les vues en plan (fig.8) et en coupe (fig.9) de trois dispositifs selon l'invention qui sont montés en cascade dans un environnement de circuit microbandes supportées par un substrat 26, en une seule ou plusieurs plaquettes. Les liaisons électriques se font au moyen de rubans métalliques 27 de longueur quasiment nulle, câblés par les techniques usuelles entre les plages de métallisations 3 qui sont en contact mécanique, ou entre les plages 3 et les microrubans extérieurs 28 qui en sont très proches. C'est une question de précision mécanique, mais il n'y a pas de rupture dans les lignes microrubans, qui de plus sont dans le même plan : faces supérieures des substrats 1 et 26. Ceci est obtenu en donnant aux semelles les mêmes dimensions latérales que les substrats.

A titre d'exemple non limitatif, sur la figure 9, le premier circuit d'interconnexion est muni sur sa face supérieure d'un circuit régulateur de tension 21, qui alimente en parallèle les MMIC 18 fixés sur les faces inférieures des substrats, double face, et les deux circuits d'interconnexion suivants sont munis chacun d'un radiateur thermique 23. Dans le but de rendre la figure 8 plus claire, les composants rapportés sur la face supérieure du substrat n'y sont pas représentés.

Le dispositif d'interconnexion et de protection d'une pastille nue de composant hyperfréquence est utilisé pour des amplificateurs, oscillateurs ou autres circuits hyperfréquences, dans un domaine compris entre 0 et 60 GHz.

**Revendications**

1 - Dispositif d'interconnexion et de protection d'une pastille nue de composant semiconducteur hyperfréquence, réalisée en matériaux du groupe III-V, dans lequel le circuit d'interconnexion est situé sur la première face d'un substrat céramique (1), et le composant semiconducteur (18) est situé sur la deuxième face dudit substrat (1), la liaison entre circuit d'interconnexion et composant semiconducteur étant réalisée à travers le substrat par des trous métallisés bouchés (5), ce dispositif étant caractérisé en ce que :
- le substrat (1) est de forme carrée ou rectangulaire, et porte sur sa première face un réseau de lignes microbandes (2) dont une première extrémité (4) est proche d'une plage centrale (6) et dont une deuxième extrémité (3) est sur l'un des deux bords opposés du substrat (1), qui porte sur sa deuxième face une métallisation de plan de masse (8) dont la plage centrale (11), comprise entre des réserves (9) nécessaires à l'isolement des dits trous métallisés bouchés (5), est de dimensions suffisantes pour pouvoir y fixer au moins une pastille nue de composant semiconducteur (18), dont les plots de connexions sont reliés par fils ou rubans métalliques (19) aux trous métallisés bouchés (5)

- une semelle métallique, dont la partie centrale (12) a les mêmes dimensions que le substrat (1) et comporte un amincissement (13) créant une alvéole pour loger la pastille nue du composant semiconducteur (18), est fixée sur le substrat (1), au moyen de sa métallisation de plan de masse (8), ladite semelle comportant également, sur deux côtés opposés, deux embôuts métalliques (14), percés chacun d'un trou (15), les embouts étant placés, par rapport au substrat (1), sur les deux autres bords opposés que ceux qui portent les secondes extrêmités (3) des lignes microbandes (2), rendant ainsi ledit dispositif d'interconnexion cascadable.

2 - Dispositif d'interconnexion et de protection selon la revendication 1, caractérisé en ce que la première face du substrat (1) comporte en outre, en son centre, une plage de métallisation (6), réunie par au moins un trou (7) métallisé bouché à la métallisation de plan de masse (8) de la deuxième face du substrat, cette plage de métallisation centrale (6) constituant ainsi une plage de report d'un composant (21) mis à la masse.

3 - Dispositif d'interconnexion et de protection selon la revendication 1, caractérisé en ce que les lignes microbandes (2), portées par la première face du substrat (1), sont munies, chacune, à leur extrêmité au bord du substrat, d'une plage métallisée (3) permettant d'interconnecter le dispositif à un circuit microbandes extérieur, tel qu'un autre dispositif comparable monté en cascade, au moyen d'un ruban métallique (27), sans rupture d'impédance.

4 - Dispositif d'interconnexion et de protection selon la revendication 1, caractérisé en ce que les trous (5,7) métallisés qui traversent le substrat (1) sont bouchés au moyen d'une pâte à braser or-étain ou or-germanium, qui subit une refusion, lesdits trou (5,7) traversant les lignes microbandes (2) et les plages de métallisation (6,8).

5 - Dispositif d'interconnexion et de protection selon les revendications 1 et 2, caractérisé en ce que le substrat (1) supporte un circuit double face qui comporte en outre :

- sur sa première face, externe, des composants auto-protégés tels que pastilles de composants en silicium (21), capacités (22), radiateurs (23),

- sur sa deuxième face, protégés à l'intérieur de l'alvéole de la semelle (12), des composants d'environnement hyperfréquence d'au moins une pastille nue (18) de composant en matériaux III-V, tels que capacités (20) ou selfs (19).

6 - Dispositif d'interconnexion et de protection selon les revendications 1 et 2, caractérisé en ce que le réseau d'interconnexion, constitué par les lignes microbandes (2) d'accès à la pastille nue de composant hyperfréquence (18), est adapté en impédance et en fréquence, par la largeur des lignes microbandes (2) par rapport à l'épaisseur et à la constante diélectrique du substrat (1), et ajusté au moyen de plots métallisés (25) voisins des lignes microbandes (2), sur la première face du substrat (1).

7 - Dispositif d'interconnexion et de protection selon l'une quelconque des revendications 1 à 6, caractérisé en ce que le composant hyperfréquence (18) est une pastille nue de circuit intégré (MMIC), en matériaux tels que GaAs ou Al GaAs.

FIG 1

FIG 2

FIG 3

FIG 4

FIG 5

FIG 6

FIG 7

FIG 8

FIG 9

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| Y | FR-A-2 507 409 (RTC) <br> * Page 4, ligne 1 - page 6, ligne 4; figures 1,3; revendication 1 * <br> --- | 1,3 | H 01 L 23/56 <br> H 01 L 23/50 |
| Y | EP-A-0 177 943 (FUJITSU LTD) <br> * Figures 5,8; page 5, lignes 13-24; page 7, lignes 26-28 * <br> --- | 1,3 | |
| A | US-A-4 276 558 (FORD AEROSPACE) <br> * En entier * <br> --- | 1,3,7 | |
| A | PATENT ABSTRACTS OF JAPAN, vol. 6, no. 132 (E-119)[1010], 17 juillet 1982, page 15 E 119; & JP-A-57 056 953 (NIPPON DENKI K.K.) 05-04-1982 <br> --- | 2,7 | |
| A | PATENT ABSTRACTS OF JAPAN, vol. 5, no. 44 (E-50)[716], 24 mars 1981, page 96 E 50; & JP-A-55 166 941 (NIPPON DENKI K.K.) 26-12-1980 <br> --- | 1,2 | |
| A | PATENT ABSTRACTS OF JAPAN, vol. 5, no. 8 (E-223)[1454], 25 janvier 1984, page 148 E 223; & JP-A-58 182 251 (MITSUBISHI DENKI K.K.) 25-10-1983 <br> --- | 1,3,5 | DOMAINES TECHNIQUES RECHERCHES (Int. Cl.4) <br><br> H 01 L 23/00 |
| A | EP-A-0 187 580 (THOMSON-CSF) <br> * Figures 1,5; page 4, lignes 4-32 * <br> ----- | 1 | |

Le présent rapport a été établi pour toutes les revendications

| Lieu de la recherche | Date d'achèvement de la recherche | Examinateur |
|---|---|---|
| LA HAYE | 29-06-1989 | DELPORTE B.P.M. |

EPO FORM 1503 03.82 (P0402)